Europäisches Patentamt

European Patent Office

Office européen des brevets

(11) Numéro de publication: **0 128 799**
A1

# DEMANDE DE BREVET EUROPEEN

(21) Numéro de dépôt: 84401030.6

(51) Int. Cl.³: **H 01 L 25/16,** H 01 L 23/52

(22) Date de dépôt: 18.05.84

(30) Priorité: 03.06.83 FR 8309287

(43) Date de publication de la demande: **19.12.84**
**Bulletin 84/51**

(84) Etats contractants désignés: **DE GB IT NL SE**

(71) Demandeur: **THOMSON-CSF, 173, Boulevard Haussmann, F-75379 Paris Cedex 08 (FR)**

(72) Inventeur: **Boniteau, Georges, THOMSON-CSF SCPI 173, bld Haussmann, F-75379 Paris Cedex 08 (FR)**

(54) **Procédé de réalisation d'un circuit hybride, et circuit hybride obtenu par ce procédé.**

(57) Procédé de réalisation d'un circuit hybride comportant des composants actifs et passifs, comprenant une première étape de collage des composants sur une face d'une plaquette de substrat isolant et une deuxième étape de liaison électrique entre ces composants, par soudage de fils conducteurs isolés reliant des plots de connexion des composants, plots situés soit sur les composants eux-mêmes, soit sur la plaquette de substrat de part et d'autre de chaque composant.

    Circuit hybride logique ou analogique, réalisé selon un tel procédé, utilisé dans des matériels civils ou militaires.

ACTORUM AG

0128799

1

# PROCEDE DE REALISATION D'UN CIRCUIT HYBRIDE
# ET CIRCUIT HYBRIDE OBTENU PAR CE PROCEDE

L'invention concerne un procédé de réalisation d'un circuit hybride, intéressant le domaine de la microélectronique hybride couvrant les besoins des matériels civils, comme le téléphone ou des appareils de mesure, et des matériels militaires, radars par exemple. Elle a également pour objet un circuit hybride, logique ou analogique, obtenu par ce procédé.

Actuellement, la réalisation de circuits hybrides logiques ou analogiques se fait à partir de composants actifs, circuits intégrés réalisés sous forme de puces ou pastilles, et de composants passifs miniaturisés, réalisés sous forme de pavés ou "chipses", en vocable anglo-saxon, connectés entre eux par des dépôts conducteurs mono ou multicouches sur les plaquettes de substrat isolant (céramique, verre...). En effet, les liaisons électriques entre les différents circuits sont réalisées par des petits fils conducteurs soudés, d'une part, aux composants et, d'autre part, à des pistes conductrices déposées soit sur une seule couche de substrat isolant, soit sur plusieurs couches superposées. Une semblable réalisation suppose auparavant une conception théorique de l'implantation des différents circuits et de la disposition des nombreuses pistes conductrices les unes par rapport aux autres, conception longue et compliquée. Ensuite, la réalisation pratique des multiples couches du circuit hybride est relativement longue et coûteuse.

Un tel procédé de réalisation selon l'art antérieur ne permet pas de construire des maquettes de circuits hybrides logiques ou analogiques complexes dans un délai court. En effet, la conception de telles maquettes est identique à celle des circuits hybrides à réaliser, aussi bien en ce qui concerne l'étude des dessins d'implantation que la réalisation pratique du circuit hybride lui-même. A ce premier inconvénient s'ajoute celui de ne pouvoir modifier, après expérimentation des maquettes ainsi conçues, les liaisons non accessibles d'un dépôt multicouche, puisqu'il n'est plus question de couper une piste conductrice par exemple prise entre deux couches de substrat isolant. Toute modification de la maquette nécessite une nouvelle implantation des composants et une nouvelle réalisation, entraînant un prix de revient très élevé pour une maquette définitive.

Le but de l'invention est de concevoir un procédé de réalisation d'un circuit hybride qui réduit considérablement le temps d'implantation et de fabrication du circuit lui-même et qui permet d'y apporter des modifications sans entraîner un prix de revient trop élevé, grâce à l'accessibilité de toutes les liaisons électriques.

La présente invention a donc pour objet un procédé de réalisation d'un circuit hybride comportant des composants passifs et/ou actifs, discrets et/ou intégrés comportant :
- une première étape de fixation des composants sur une face d'une plaquette de substrat isolant ;
- une deuxième étape de liaison électrique entre les composants par soudage de fils conducteurs isolés reliant électriquement des plots de connexion des différents composants.

D'autres caractéristiques et avantages de l'invention apparaîtront dans la description suivante, illustrée par les dessins annexés représentant :
        - la figure 1 : une vue en coupe transversale d'un circuit hybride réalisé selon un premier mode de réalisation, suivant l'invention ;
        - la figure 2 : une vue de face d'un circuit hybride selon l'invention ;
        - la figure 3 : une vue en perspective ;
        - la figure 4 : une vue de face d'un second mode de réalisation d'un circuit hybride réalisé selon l'invention.

3

- la figure 5 : une vue en coupe transversale d'un circuit hybride réalisé selon un troisième mode de réalisation suivant l'invention ;

- les figures 6 et 7 : une vue en perspective de chacune des deux faces du circuit hybride selon le troisième mode de réalisation de l'invention.

Les éléments portant les mêmes références dans les différentes figures remplissent les mêmes fonction en vue des mêmes résultats.

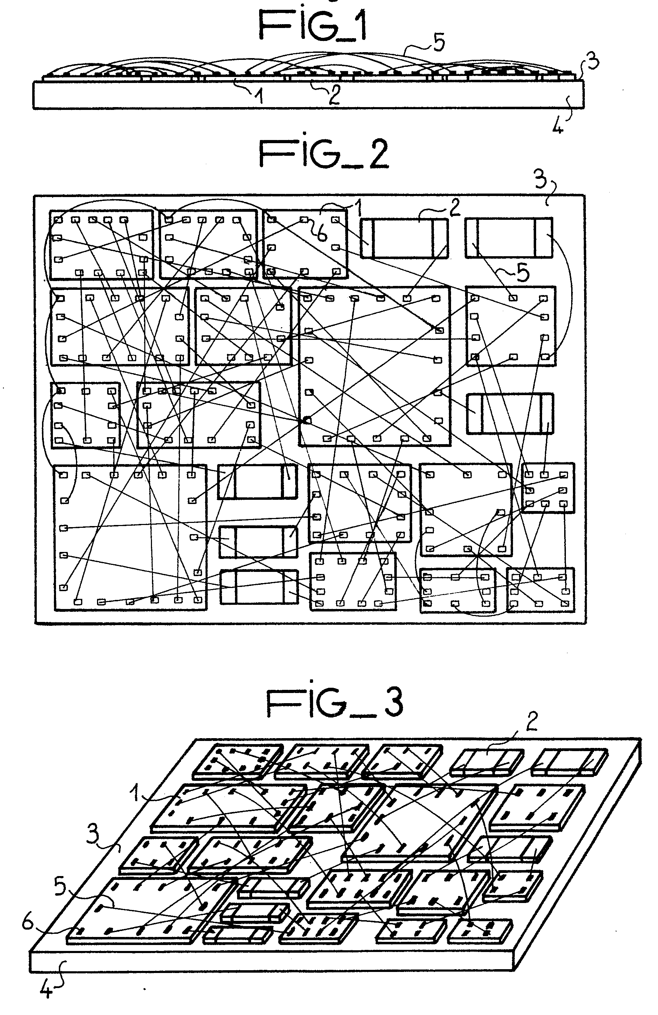

Comme cela a été mentionné plus haut, le procédé de réalisation d'un circuit hybride représenté sur les figures 1 à 3 selon l'invention comporte essentiellement deux étapes.

Une première étape consiste à fixer les différents composants actifs 1 et passifs 2 - c'est à dire soit des puces ou pastilles de circuits actifs, discrets ou intégrés, soit des résistances ou des condensateurs réalisés en miniature sous forme de "chipses" - sur une face 3 d'une plaquette 4 de substrat isolant - de la céramique par exemple -Ces composants sont placés côte à côte de façon à réduire au maximum l'encombrement de l'ensemble et à minimiser la longueur des liaisons électriques à réaliser. La fixation peut s'effectuer par collage.

Dans une seconde étape, les liaisons électriques entre ces différents composants sont assurés au moyen de fils conducteurs 5 enrobés d'un produit isolant, évitant les court-circuits en cas de croisement de ces fils, les fils 5 étant soudés aux plots de connexion 6 disposés sur chacun des composants 1 ou 2 dans un premier mode de réalisation représenté sur les figures 1 à 3. Ces fils conducteurs 5 sont par exemple en or, en cuivre ou en aluminium, isolés. Pour chaque liaison électrique entre deux plots 6 appartenant à deux composants différents à connecter, les deux extrémités du fil de connexion 5 sont soudées aux plots correspondants par un procédé de

4

classique de microsoudure.

En cas de manipulations fréquentes ou d'essais de vibration, on peut immobiliser les fils de connexion ainsi soudés par une résine déposée sur la face de la plaquette de substrat les supportant, cette résine étant soit pulvérisée, soit moulée ou bien encore déposée par trempage du circuit hybride lui-même dans un bain de résine.

La conception d'une maquette de circuit hybride selon ce procédé est beaucoup plus rapide que celle de l'art antérieur car il suffit de positionner de façon adéquate les différents composants sur une simple plaquette de substrat isolant et de les relier par des fils, sans avoir à concevoir initialement toute une implantation de pistes de connexion placées entre différentes couches de substrat isolant. Il faut ajouter que le nombre de soudures est réduit de moitié puisque les fils sont connectés directement entre les composants. Ainsi, il devient beaucoup plus facile de valider des schémas complexes de circuits hybrides, à moindre frais.

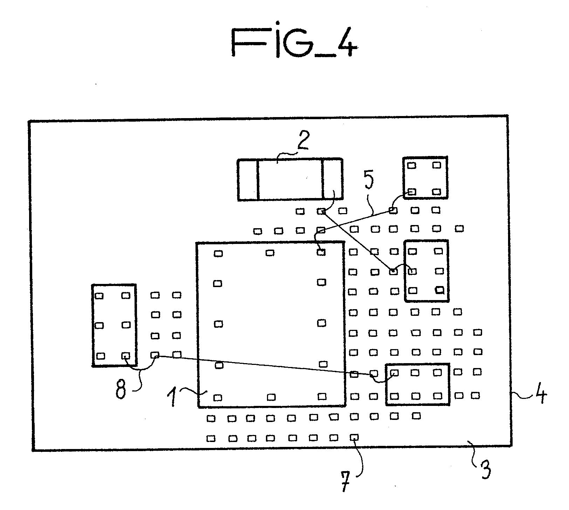

Selon un second mode de réalisation du procédé, représenté sur la figure 4, la plaquette 4 de substrat isolant comporte une multitude de plots conducteurs 7 disposés régulièrement sur une de ses faces 3, suivant des lignes et des colonnes de directions orthogonales. On dispose les composants actifs 1 et passifs 2 sur cette face 3 de la plaquette, de façon toujours à minimiser l'encombrement et à réduire la longueur des connexions électriques, mais de sorte qu'entre deux composants voisins il y ait deux rangées de plots de connexion 7. Dans ce mode de réalisation, les liaisons électriques entre deux composants se font par soudure de fils conducteurs isolés 5 entre deux plots 7 situés sur la face 3 de la plaquette 4, et correspondant chacun à un des deux composants, la liaison électrique entre chaque composant et le plot correspondant se fait par un petit fil conducteur 8, soudé selon un procédé classique dit de "bonding" utilisé dans l'art antérieur pour relier électriquement les composants aux pistes conductrices.

5

Par rapport au premier mode de réalisation du procédé selon l'invention, ce second mode présente l'avantage de permettre de désouder des fils 5, 8 créant des liaisons électriques à modifier, à condition cependant que les fils ne soient pas immobilisés dans de la résine.

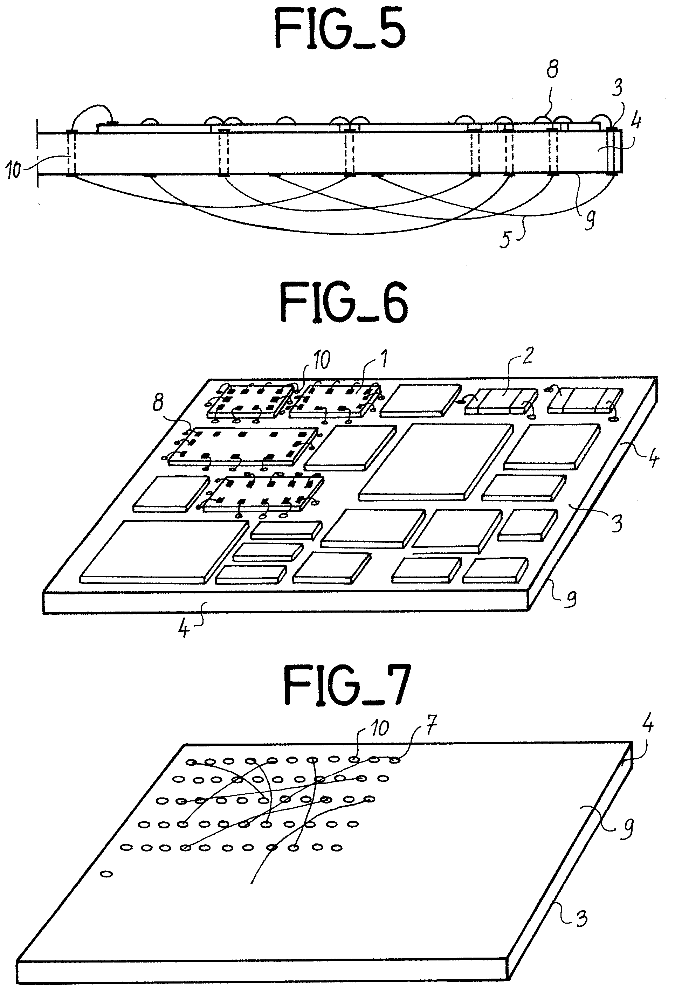

Il existe un troisième mode de réalisation d'un circuit hybride selon l'invention, représenté sur la figure 5 selon une vue en coupe transversale de la plaquette de substrat et sur les figures 6 et 7 selon une vue en perspective de chacune des deux faces de la plaquette.

Cette plaquette 4 de substrat isolant comporte une pluralité de trous métallisés 10 disposés régulièrement, en quinconque ou non, à travers toute l'épaisseur de la plaquette, suivant des lignes et des colonnes de directions orthogonales. Les deux extrémités de chaque trou 10 aboutissent à des plots de connexion métallisés disposés sur les deux faces 3 et 9 de la plaquette 4. On dispose les composants actifs 1 et passifs 2 sur une des deux faces 3 de la plaquette 4 de façon à minimiser la longueur de l'encombrement et à réduire la longueur des connexions électriques mais de sorte qu'il y a deux rangées de plots 7 entre deux composants voisins. Dans ce troisième mode de réalisation, les liaisons électriques entre deux composants se font par soudage de fils conducteurs isolés 5 entre deux plots 7 situés sur l'autre face 9 de la plaquette 4 et correspondant chacun à un des deux composants ; la liaison électrique entre chaque composant et le plot correspondant se fait par un petit fil conducteur 8 soudé sur la face 3 selon un procédé classique dit de "bonding". Le troisième mode de réalisation présente l'avantage de câbler tous les fils conducteurs isolés 5 sur une des faces 9 de la plaquette de substrat 4 permettant ainsi de tester l'isolement et la bonne continuité des connexions avant même de disposer et de souder les composants actifs 1 et passifs 2. De plus, quand il est nécessaire de changer un de ces composants, ce changement peut se faire sans intervention sur les fils conducteurs isolés 5.

0128799

6

Là encore, il est possible d'immobiliser les fils conducteurs isolés 5 dans une résine isolante.

Ainsi le procédé de réalisation d'un circuit hybride qui vient d'être décrit permet de réaliser des circuits de grande complexité dans un délai considérablement plus court que par le procédé antérieur dans un délai considérablement plus court que par le procédé antérieur et à moindre frais. D'où son grande intérêt dans la conception et la réalisation de maquettes de circuits hybrides, que l'on peut alors valider plus facilement et plus rapidement avant une simulation sur ordinateur par exemple. Les circuits hybrides réalisés par ce procédé peuvent être utilisés dans des matériels civils tels que des calculateurs, des ordinateurs, des téléphones, etc. mais aussi dans des matériels militaires notamment radar, pour lesquels ils doivent présenter un encombrement réduit au maximum et tenir les variations de température imposées par les normes militaires, c'est-à-dire -55°C à + 125°C.

L'invention n'est pas bien entendu limitée aux modes de réalisation décrits et représentés. Elle comprend également tous les équivalents techniques des moyens décrits ainsi que leurs combinaisons, si celles-ci sont effectuées suivant l'exprit de l'invention et mises en oeuvre dans le cadre des revendications qui suivent.

REVENDICATIONS

1. Procédé de réalisation d'un circuit hybride comportant des composants passifs (2) et/ou actifs (1), discrets et/ou intégrés, caractérisé en ce qu'il comprend :
- une première étape de fixation des composants sur une face (3) d'une plaquette (4) de substrat isolant, de façon à minimiser la longueur des connexions électriques à réaliser entre ces composants ;
- une deuxième étape de liaison électrique entre les composants par soudage de fils conducteurs isolés (5), reliant électriquement des plots de connexion des différents composants.

2. Procédé selon la revendication 1 caractérisé en ce que les fils conducteurs (5) sont en or, en cuivre ou en aluminium enrobés d'un produit isolant.

3. Procédé selon les revendications 1 ou 2, caractérisé en ce que les plots de connexion (6) sont situés sur les composants (1, 2) eux-mêmes.

4. Procédé selon les revendications 1 ou 2, caractérisé en ce que les plots de connexion (7) sont situés de part et d'autre de chaque composant (1, 2) sur la face (3) de la plaquette (4) de substrat isolant sur laquelle sont fixés les composants.

5. Procédé selon la revendication 4, caractérisé en ce que les plots de connexion (7) sont répartis régulièrement sous forme de lignes et de colonnes de directions orthogonales, sur toute la surface (3) de la plaquette (4) de substrat isolant.

6. Procédé selon revendication 5, caractérisé en ce que :
- la première étape de fixation des composants sur la face (3) de la plaquette (4) est telle qu'il existe deux lignes ou deux colonnes de plots de connexion (7) entre deux composants voisins ;

- la deuxième étape de liaison électrique entre les composants comporte un premier soudage de fils conducteurs isolés (5) reliant chacun deux plots (7) situés sur la face (3) de la plaquette (4) et correspondant à deux composants distincts, et un deuxième soudage de fils conducteurs (8) reliant chacun un composant et le plot (7) de connexion correspondant.

7. Procédé selon les revendications 1 ou 2, caractérisé en ce que la plaquette (4) de substrat isolant comporte une pluralité de trous métallisés (10) aboutissant à des plots de connexion métallisés disposés sur les deux faces (3 et 9) de la plaquette (4), opposées l'une de l'autre, ces trous étant disposés régulièrement selon des lignes et des colonnes de directions orthogonales.

8. Procédé selon la revendication 7, caractérisé en ce que :
- l'étape de fixation des composants sur la face (3) de la plaquette (4) est telle qu'il existe deux lignes ou deux colonnes, entre deux composants voisins, de trous métallisés (10) aboutissant à des plots de connexion.
- l'étape de liaison électrique entre les composants comporte un premier soudage de fils conducteurs isolés (5) reliant chacun deux plots (7) situés sur la face (9) de la plaquette (4) et correspondant à deux composants distincts et un deuxième soudage de fils conducteurs (8) reliant chacun un composant et le trou métallisé (10) correspondant.

9. Procédé selon les revendications 1, 6 et 8, caractérisé en ce que l'étape de fixation des composants consiste en un collage.

10. Procédé selon l'une quelconque des revendications 1 à 9, caractérisé en ce que, pour chaque liaison électrique réalisée par un fil conducteur isolé entre deux plots de connexion, les deux extrémités du fil sont raccordées aux plots correspondants par un procédé de microsoudure.

11. Procédé selon l'une quelconque des revendications 1 à 10 caractérisé en ce qu'il comporte en outre une troisième étape d'immobilisation de fils conducteurs dans une résine isolante, déposée par pulvérisation, trempage ou moulage.

12. Procédé selon l'une quelconque des revendications 1 à 10 caractérisé en ce qu'il comporte une troisième étape de mise du circuit hybride dans un boîtier hermétique.

13. Circuit hybride logique ou analogique, caractérisé en ce qu'il est obtenu à partir du procédé selon l'une des revendications 1 à 12.

FIG_1

FIG_2

FIG_3

FIG_4

0128799

3/3

# FIG_5

# FIG_6

# FIG_7

Office européen
des brevets

**RAPPORT DE RECHERCHE EUROPEENNE**

EP  84 40 1030

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | US-A-4 241 360  (GALILEO ELECTRO-OPTICS)<br><br>* Figures 1,4,6,8; revendications 1,5;  colonne  3,  lignes  20-24, 46-54;  colonne  4,  ligne  65  - colonne 5, ligne 2 *<br><br>--- | 1,2,5-8,10, 11 | H 01 L  25/16<br>H 01 L  23/52 |
| X | GB-A-1 024 216  (STANDARD TEL. AND CABLES)<br>*  Figure  2;  page  2,  lignes 84-101,119-124 *<br><br>--- | 1,3,9, 10,13 | |
| A | US-A-3 469 148  (GENERAL MOTORS)<br><br>*  Colonne  1,  lignes  52-58; colonne  2, lignes 33-44; colonne 3, lignes 3-8 *<br><br>----- | 1,2,10 -12 | |
| | | | **DOMAINES TECHNIQUES RECHERCHES (Int. Cl. 3)**<br><br>H 01 L |

Le présent rapport de recherche a été établi pour toutes les revendications

| Lieu de la recherche<br>LA HAYE | Date d'achèvement de la recherche<br>11-09-1984 | Examinateur<br>DE RAEVE R.A.L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

 

& : membre de la même famille, document correspondant

OEB Form 1503. 03.82